# EUROPEAN PATENT SPECIFICATION

(11) **EP 0 439 752 B1**
(45) Date of publication and mention of the grant of the patent: **19.04.1995**
(21) Application number: 90124054.9
(22) Date of filing: 13.12.1990
(51) Int. Cl.: H01L 23/367, H01L 23/42, H01L 23/14

(54) **Integrated circuit packaging structure**
Packungsstruktur für integrierte Schaltung
Structure d'empaquetage pour circuit intégré

(30) Priority: 29.01.1990 US 472501
(43) Date of publication of application: 07.08.1991
(73) Proprietor: International Business Machines Corporation, Armonk, N.Y. 10504 (US)
(72) Inventor: Mok, Lawrence S., Yorktown Heights, N.Y. 10598 (US); Schwall, Robert E., Ridgefield, Connecticut 06877 (US); Tong, Ho-Ming, Yorktown Heights, N.Y. 10598 (US)
(74) Representative: Schäfer, Wolfgang, Dipl.-Ing.

(56) References cited:
- EP-A- 0 009 605
- FR-A- 2 570 383
- IBM TECHNICAL DISCLOSURE BULLETIN. vol. 32, no. 2, July 1989, NEW YORK US page413 ANONYMOUS: "Surface mount passive superchip module"
- IBM TECHNICAL DISCLOSURE BULLETIN. vol. 27, no. 7A, December 1984, NEW YORK USpage 3915 J.L.HORVATH: "Cooling assembly for solder-bonded semiconductor
- devices"
- IBM TECHNICAL DISCLOSURE BULLETIN. vol. 27, no. 11, April 1985, NEW YORK USpage 6726 ANONYMOUS: "Heat pipe pin fin cap"
- IBM TECHNICAL DISCLOSURE BULLETIN. vol. 28, no. 7, December 1985, NEW YORK USpages 3058 - 3059; ANONYMOUS: "High performance air-cooled module"

## Description

The invention relates to an integrated circuit packaging structure having a wafer member to which on one side at least one integrated circuit semiconductor chip is bonded, said wafer being resiliently mounted on the periphery with the other side of said wafer being in broad area conformal thermal transfer with an external heat dissipating structure.

Progress in semiconductor technology has led to increased component density both in the integrated circuit chips themselves and in the packaging of the chips in assemblies of several chips known in the art by the term modules. The modules contain a group of interwired chips mounted in a housing assembly that facilitates attachment and connection to external wiring and dissipation of heat. While at the increased density, the individual chips involve very low currents, at the present state of the art the number of devices per chip may approach hundreds of thousands and the number of chips per module may approach a quantity of the order of a hundred, so that heat transfer has now become a most serious consideration.

One type of module package heretofore in the art transfers heat produced in the chip to the housing from the back of the chip through a viscous but conformal material, such as: a liquid metal as shown in U.S. Patent 4,323,914; an oil filled porous layer as shown in U.S. Patent 4,823,863; a thermal grease as shown in US-A-4 567 505; and a thermal grease with a conformal foil as shown in IBM Technical Disclosure Bulletins Vol. 21, No. 1, June 1978, page 185 and Vol. 21, No. 4, September 1978, page 1473.

Another type of module package heretofore in the art employs an intermediate wafer of silicon on which is disposed some distribution wiring supported by a center post to provide thermal expansion movement and to which the chip contacts are bonded. One such module relies on a special material, A1N, as part of the package, shown in "Ultra Reliable HWSI With Aluminum Nitride Packaging" by J.K. Hagge in Electronic Packaging and Production, Sept. 1979, page 1271. Another such module shown in U.S. Patent 3,999,105 employs liquid encapsulation.

Further it is known by IBM Technical Disclosure Bulletin, Vol. 32, No. 2, July 1988, page 413 an integrated circuit package having a wafer to which on one side at least one integrated circuit semiconductor chip is bonded, said wafer having its other side in broad area conformal thermal transfer with an external heat dissipating structure. However, this wafer is not resiliently mounted on its periphery.

The use of the center post supported intermediate wafer, of the same or thermal expansion matched material such as monocrystalline silicon, as density increases and dimensions decrease, may involve unpredictability and somewhat extensive movement since all heat may not be uniformly generated. In such a situation, fractures could appear in the intermediate wafer after only a few thermal cycles.

An integrated circuit packaging principle in which chips are bonded to one side of an intermediate wafer that is resiliently mounted at the periphery with the entire other side of the intermediate wafer being maintained in conformal thermal transfer to external heat dissipation, is free of any solid connection.
- Fig. 1: is a cross sectional schematic view of the structure of the invention.
- Fig. 2: is a perspective schematic view of the relative positioning of the structural elements in the invention.
- Figs. 3 and 4: are schematic sketches of different positioning of the resilient intermediate wafer mounting.
- Fig. 5: is a schematic illustration of the application of a measured quantity of thermal grease in a method of the assembly of the structure of the invention.

In accordance with the invention, a module type package containing a plurality of interwired chips adapted for positioning on an external wiring bearing substrate is provided at set out in claim 1. Preferred embodiments of the invention are set out in the dependent claims. The structure of the invention provides a simple construction that permits a radical improvement in heat cycles in service.

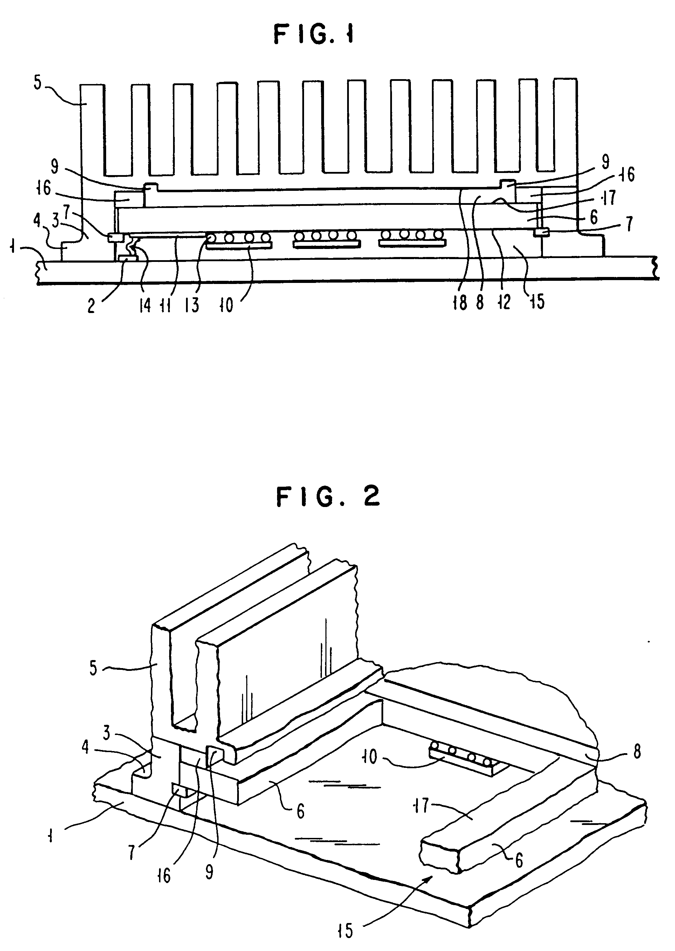

Referring to Fig. 1, on an external wiring bearing substrate 1 such as a printed circuit where the wiring is shown schematically as element 2, there is positioned a module housing 3 having a number of interdependent features. The housing 3 is equipped with: a means of attachment 4 to the external wiring substrate 1 shown as pads for soldering; means for heat dissipation shown schematically as fins for transfer to a fluid medium such as air or a liquid; an intermediate wafer 6 supporting and positioning means 7 shown schematically as a removable member and may include a thermal grease 8 expansion accommodation means 9 shown schematically as a groove into and out of which the thermal grease 8 can move when heat generated in service causes the intermediate wafer 6 to change shape. The thermal grease 8 is a suspension of high thermal conductivity solid particles, such as zinc oxide or ceramic, suspended in silicone or mineral oil. The material is normally a paste.

The module package employs an intermediate wafer 6 chip mounting member. The intermediate wafer 6 is a close thermal match to the semiconductor material the chips 10 which are mounted on wiring 11 shown schematically as a conductor. The intermediate wafer 6 is preferably made of a silicon monocrystalline wafer. Such wafers are about 0.51 mm (0.02 inches) thick. The use of the silicon monocrystalline material provides high flexibility but such material will fail rapidly in service if mounted so that stresses that occur with solid connections begin cracks in the wafer. An alternate wafer 6 construction could be from composite materials, such as copper-Invar-copper, copper-molybdenum-copper or more general composites containing these materials.

The chips 10 are mounted on the side 12 of the intermediate wafer that is next to the surface of the external wiring bearing substrate 1 on which the housing 3 is mounted. The chips 10 are mounted by bonding the electrical terminals thereon, shown schematically as elements 13 to the conductors 11. The conductors 11 are connected to the external wiring on the substrate 1 by a resilient conductive connection 14 shown schematically as flexible wire. There is a space 15 between the chips 10 and the substrate 1.

The intermediate wafer 6 rests on the element 7 on one side with the other side being spaced from element at the periphery thereof by a resilient member 16. The edges of the intermediate wafer 6 are a movement acommodating fit in the housing 3. Element 16 serves to retain the intermediate wafer 6, while permitting expansion movement and also serves to confine lateral movement with respect to surface 17 of the thermal grease 8. The peripheral enclosure formed by element 16 also operates to relax viscosity requirements on the thermal grease 8. The element 16 may be made of silicone rubber adhesively attached to the surface 18. Such a structure is stable as low as -40°C and as high as +12°C with a desired operating temperature around +8°C.

In operation, in a very simple structure, the heat produced in operation is conducted away from the chips with accommodation for the various types of stresses and the potential temperature cycle damage that occurs.

The intermediate wafer 6 expansion match with the chips controls the stresses where the terminals 13 are conductively bonded to the wiring 11. The flexibility of the intermediate wafer 6 controls the differences in local expansion where one chip 10 produces more heat than another. The formation of stresses in the intermediate wafer 6 is controlled by the flexible peripheral mounting 16 which permits uneven support while avoiding any rigid connection.

The heat is transferred through conduction through the terminals 13 to the intermediate wafer 6 and then via the thermal grease 8 over the entire area of the surface 17 to the housing 3 and heat dissipation means.

Referring next to Fig. 2, the interdependent aspects of the parts and the structural simplicity of the invention are further illustrated in a perspective schematic view employing the same reference numerals. In Fig. 2, on a portion of the substrate 1, a portion of the housing 3 is attached at element 4. The intermediate wafer 6 rests on the element 7 which establishes peripheral support in one direction and the spacing 1. The intermediate wafer 6 is further spaced in the other direction by the peripheral resilient spacer member 16. On the intermediate wafer 6 there is the measured quantity of thermal grease 8 confined at the eriphery by the resilient spacer member 16 and on one side by the surface 17 of the intermediate wafer 6 and on the other side by the surface 18 with expansion into and out of available space at element 9.

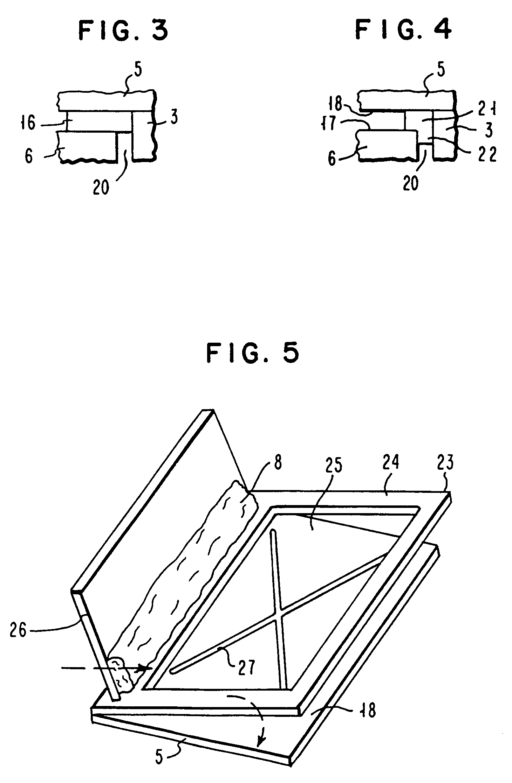

Referring next to Figs. 3 and 4, which show different positionings of the resilient spacer 16. In Fig. 3, the resilient spacer 16 is positioned at the intersection of the change of direction of the housing 3 with a spacing 20 provided to permit the intermediate wafer to flex without bonding on the housing 3. In Fig. 4, a different shaped resilient spacer 21 is provided that has a portion 22 that extends into the spacer 20 to facilitate lateral positioning of the intermediate wafer 6.

Referring next to Fig. 5, the simplicity of the structure and ease of assembly is illustrated in a schematic illustration of the application of the measured quantity of the thermal grease 8. In Fig. 5, a perspective assembly schematic is shown in which a spacer mold 23 is a simple stamping of, for example, brass shim stock with a width 24 between the measured quantity defining opening 2 and the edge of the spacer mold 23 such that the edges of the opening 2 coincide with the inside edges of the resilient spacer element 16. The member 23 has a thickness essentially equal to the thickness of the element 16. When positioned in contact with the intermediate wafer 6 as shown by the curved dotted arrow, a standard doctor blade 26 in a motion indicated by the straight dotted arrow deposits a measured quantity of thermal grease 8 on the surface 18. An alternate thermal grease expansion accommodation means 9 is shown as element 27 which is an X shaped groove in the surface 18.

The overall assembly merely involves the steps of fabricating the spacer mold 23, which defines the periphery and thickness of the measured quantity of thermal grease 8, the positioning of the spacer mold 23 in contact with the surface 18, the depositing of the measured quantity of thermal grease 8, the positioning on the surface 18 of the heat dissipator of the resilient spacer 16 and the assembly of the wafer 6 and grease 8-heat dissipator combination to the housing 3.

What has been described is an integrated circuit packaging principle wherein an intermediate chip bearing wafer is free to change shape during use while providing full surface area heat transfer.

## Claims

1. An integrated circuit packaging structure for mounting to an external wiring bearing substrate, said packaging structure including a housing (3) carrying an external heat dissipating structure (5), said packaging structure comprising:
a wafer member (6) to which on one side thereof at least one integrated circuit semiconductor chip (10) is bonded, the other side of said wafer being in broad area conformal thermal transfer with said external heat dissipating structure (5),
characterised in that
said external heat dissipating structure (5) has an inner cavity,
said wafer (6) is resiliently mounted on the periphery thereof to said housing (3),
a peripheral resilient spacer (16) is disposed along the edge of said wafer member (6) between said wafer member (6) and said heat dissipating means (5) forming a closed cooling cavity defined by the inner cavity of the external heat dissipating structure (5), the peripheral resilient spacer and the said other side of the wafer, said cooling cavity being filled with a viscous thermally conductive material (8),
the said one side of the wafer (6) facing the external wiring bearing circuit to which the packaging structure is to be mounted, whereby the chips are enclosed in a space defined by the said one side of the wafer, the housing (3), and the external wiring bearing circuit (1) to which the packaging structure is to be mounted, and said wafer member (6) being of a material having a thermal expansion match to semiconductor material.

2. Structure of claim 1 including displacement control means for said thermally conductive material (8).

3. Structure of claim 2 wherein said displacement control means is a groove (9, 27).

4. Structure of anyone of the claims 1 to 3 wherein said resilient spacer (16) is of silicone rubber.

5. Structure of claim 1 wherein said wafer member (6) is of semiconductor material.

6. The structure of claim 1 wherein said wafer member (6) is of a composite material.

7. Structure of anyone of the claims 4 to 6 wherein said semiconductor electronic device (10) is an integrated circuit of the same semiconductor material as said wafer member (6).

8. Structure of claim 7 wherein said semiconductor material is silicon.

## Patentansprüche

1. Packungsstruktur für integrierte Schaltungen zur Anbringung an ein eine externe Verdrahtung tragendes Substrat, wobei die Packungsstruktur ein Gehäuse (3) beinhaltet, das eine externe Wärmeabstrahlungsstruktur (5) trägt, wobei die Pakkungsstruktur folgendes beinhaltet:
ein Waferelement (6), an das an einer Seite wenigstens ein Halbleiterchip (10) mit integrierter Schaltung gebondet ist, wobei sich die andere Seite des Wafers in breitflächigem, konformem thermischem Austausch mit der externen Wärmeabstrahlungsstruktur (5) befindet,
dadurch gekennzeichnet, daß
die externe Wärmeabstrahlungsstruktur (5) einen inneren Hohlraum aufweist,
der Wafer (6) an seinem Rand elastisch am Gehäuse (3) befestigt ist,
ein peripherer elastischer Abstandshalter (16) längs des Randes des Waferelementes (6) zwischen dem Waferelement (6) und den Wärmeabstrahlungsmitteln (5) angeordnet ist, wobei ein geschlossener, durch den inneren Hohlraum der externen Wärmeabstrahlungsstruktur (5), den peripheren elastischen Abstandshalter und die andere Seite des Wafers festgelegter Kühlhohlraum gebildet wird, der mit einem viskosen thermisch leitfähigen Material (8) gefüllt ist,
die eine Seite des Wafers (6) der die externe Verdrahtung tragenden Schaltung gegenüberliegt, an welche die Packungsstruktur anzubringen ist, wodurch die Chips in einem Zwischenraum eingeschlossen sind, der durch die eine Seite des Wafers, das Gehäuse (3) und die eine externe Verdrahtung tragende Schaltung (1), an welche die Packungsstruktur anzubringen ist, definiert ist, wobei das Waferelement (6) aus einem Material mit einer Anpassung der thermischen Ausdehnung an das Halbleitermaterial besteht.

2. Struktur nach Anspruch 1, die verlagerungssteuernde Mittel für das thermisch leitfähige Material (8) beinhaltet.

3. Struktur nach Anspruch 2, wobei die verlagerungssteuernden Mittel aus einer Vertiefung (9, 27) bestehen.

4. Struktur nach einem der Ansprüche 1 bis 3, wobei der elastische Abstandshalter (16) aus Silikongummi besteht.

5. Struktur nach Anspruch 1, wobei das Waferelement (6) aus Halbleitermaterial besteht.

6. Struktur nach Anspruch 1, wobei das Waferelement (6) aus einem zusammengesetzten Material besteht.

7. Struktur nach einem der Ansprüche 4 bis 6, wobei das elektronische Halbleiterbauelement (10) eine integrierte Schaltung aus dem gleichen Halbleitermaterial wie das Waferelement (6) ist.

8. Struktur nach Anspruch 7, wobei das Halbleitermaterial Silicium ist.

## Revendications

1. Structure d'empaquetage pour circuit intégré pour montage sur un substrat comportant un câblage externe, ladite structure d'empaquetage comprenant un boîtier (3) comportant une structure externe de dissipation de chaleur (5), ladite structure d'empaquetage comprenant :
un élément de tranche (6) auquel sur un des côtés au moins une puce semiconductrice de circuit intégré (10) est soudée, l'autre côté de ladite tranche étant en condition de transfert thermique sur une large surface avec ladite structure externe de dissipation de chaleur (5),
caractérisée en ce que :
ladite structure de dissipation de chaleur externe (5) comporte une cavité intérieure,
ladite tranche (6) est montée de manière élastique à sa périphérie dans ledit boîtier (3),
une entretoise élastique périphérique (16) est disposée le long du bord dudit élément de tranche (6) entre ledit élément de tranche (6) et ledit moyen de dissipation de chaleur (5) formant une cavité de refroidissement fermée définie par la cavité intérieure de la structure externe de dissipation de chaleur (5), l'entretoise élastique périphérique et ledit autre côté de la tranche, ladite cavité de refroidissement étant remplie d'un matériau conducteur thermique visqueux (8),
ledit un des côtés de la tranche (6) faisant face au substrat comportant un câblage externe sur lequel la structure d'empaquetage doit être montée, de sorte que les puces sont enfermées dans un espace défini par ledit un des côtés de la tranche, le boîtier (3), et le substrat comportant un câblage externe (1) sur lequel la structure d'empaquetage doit être montée, et ledit élément de tranche (6) étant en un matériau ayant une compatibilité thermique avec le matériau semiconducteur.

2. Structure selon la revendication 1, comprenant un moyen de contrôle de déplacement pour ledit matériau conducteur thermique (8).

3. Structure selon la revendication 2, dans laquelle ledit moyen de contrôle de déplacement est une gorge (9, 27).

4. Structure selon une quelconque des revendications 1 à 3, dans laquelle ladite entretoise élastique (16) est en caoutchouc siliconique.

5. Structure selon la revendication 1, dans laquelle ledit élément de tranche (6) est en matériau semiconducteur.

6. Structure selon la revendication 1, dans laquelle ledit élément de tranche (6) est en matériau composite.

7. Structure selon une quelconque des revendications 4 à 6, dans laquelle ledit dispositif semiconducteur (10) est un circuit intégré du même matériau que ledit élément de tranche (6).

8. Structure selon la revendication 7, dans laquelle ledit matériau semiconducteur est du silicium.
